# EUROPEAN PATENT SPECIFICATION

(11) **EP 4 202 864 B1**
(45) Date of publication and mention of the grant of the patent: **31.12.2025**
(21) Application number: 22210344.2
(22) Date of filing: 29.11.2022
(51) Int. Cl.: G06V 20/58, G06N 20/00, B60W 60/00

(54) **ESTIMATING OBJECT KINEMATICS USING CORRELATED DATA PAIRS**
SCHÄTZUNG DER OBJEKTKINEMATIK UNTER VERWENDUNG KORRELIERTER DATENPAARE
ESTIMATION DE CINÉMATIQUE D'OBJET À L'AIDE DE PAIRES DE DONNÉES CORRÉLÉES

(30) Priority: 22.12.2021 US 202117559224
(43) Date of publication of application: 28.06.2023
(73) Proprietor: GM Cruise Holdings LLC, San Francisco, CA 94107 (US)
(72) Inventor: Symington, Andrew, San Francisco (US); Qu, Zheng, San Francisco (US)
(74) Representative: Manitz Finsterwald Patent- und Rechtsanwaltspartnerschaft mbB

(56) References cited:
- US-A1- 2019 147 610

## Description

### BACKGROUND

### 1. Technical Field

The disclosed technology provides solutions for improving estimates about object kinematics and in particular, for improving predictions about object kinematics using sensor data, such as environmental data collected by autonomous vehicle (AV) sensors.

### 2. Introduction

Autonomous vehicles (AVs) are vehicles having computers and control systems that perform driving and navigation tasks that are conventionally performed by a human driver. As AV technologies continue to advance, they will be increasingly used to improve transportation efficiency and safety. As such, AVs will need to perform many of the functions that are conventionally performed by human drivers, such as performing navigation and routing tasks necessary to provide a safe and efficient transportation. Such tasks may require the collection and processing of large quantities of data using various sensor types, including but not limited to cameras and/or Light Detection and Ranging (LiDAR) sensors disposed on the AV. In some instances, the collected data can be used by the AV to perform tasks relating to routing, planning and obstacle avoidance Prior art document US 2019/147610 A1 discloses a method for detecting objects observed by a vehicle and determining the trajectory of those objects.

### BRIEF DESCRIPTION OF THE DRAWINGS

Certain features of the subject technology are set forth in the appended claims. However, the accompanying drawings, which are included to provide further understanding, illustrate disclosed aspects and together with the description serve to explain the principles of the subject technology. In the drawings:
FIG. 1 conceptually illustrates an example environment in which a kinematic prediction model of the disclosed technology can be implemented, according to some aspects of the disclosed technology.
FIG. 2 illustrates an example system for training a kinematics model, according to some aspects of the disclosed technology.
FIG. 3 illustrates a flow diagram of an example process for training a kinematics model, according to some aspects of the disclosed technology.
FIG. 4 illustrates an example system environment that can be used to facilitate AV dispatch and operations, according to some aspects of the disclosed technology.
FIG. 5 illustrates an example processor-based system with which some aspects of the subject technology can be implemented.

### DETAILED DESCRIPTION

The detailed description set forth below is intended as a description of various configurations of the subject technology and is not intended to represent the only configurations in which the subject technology can be practiced. The appended drawings are incorporated herein and constitute a part of the detailed description. The detailed description includes specific details for the purpose of providing a more thorough understanding of the subject technology. However, it will be clear and apparent that the subject technology is not limited to the specific details set forth herein and may be practiced without these details. In some instances, structures and components are shown in block diagram form in order to avoid obscuring the concepts of the subject technology.

As described herein, one aspect of the present technology is the gathering and use of data available from various sources to improve quality and experience. The present disclosure contemplates that in some instances, this gathered data may include personal information. The present disclosure contemplates that the entities involved with such personal information respect and value privacy policies and practices.

Perception systems of autonomous vehicles (AVs) are designed to detect various objects in the surrounding environment in order to execute effective navigation and planning operations. To facilitate navigation and routing decisions, such systems are designed to detect kinematic characteristics, such as velocity and/or acceleration, of various entities or objects in the surrounding environment. In some implementations, kinematic characteristics can be estimated or predicted using a kinematics model, such as a machine-learning model that is configured to predict kinematic characteristics based on sensor data inputs, including but not limited to sensor data from one or more Light Detection and Ranging (Lidar) sensors, camera sensors, radar sensors, or the like.

One limitation to improving the accuracy of kinematics models is acquiring enough ground-truth data for training. Aspects of the disclosed technology address the foregoing limitations by providing solutions for acquiring ground-truth kinematic characteristics of various objects (such as vehicle) in an environment, and for using the ground-truth kinematics data/characteristics to improve kinematic model accuracy.

In some aspects, the acquisition of ground-truth data can be accomplished by mining recorded sensor data acquired from previous AV deployments. The recorded sensor data be, or can be extracted from, bag data recorded by various AVs over the course of various driving operations. For example, AV bag data can include raw sensor data, such as sensor data from one or more AV environmental sensors, such as one or more LiDAR sensors, radar sensors, accelerometers, and/or cameras, etc. In some aspects, the bag data may also include localization information, such as geolocation information, and/or vehicle heading information, that can identify a relative location, heading and pose of an object (e.g., a vehicle) with respect to other objects in same environment.

Bag data for a selected AV (e.g., a subject AV, or ego vehicle) can be analyzed to identify other AVs (remote vehicles or remote AVs) represented in the sensor data of the subject AV. These instances can result when the subject AV encounters the remote vehicles, such as when a remote vehicle passes through a field-of-view (FOV) of sensors of the subject AV. As discussed in further detail below, identification of various remote vehicles can be based on a filtering process, whereby geolocation and timing information is used to determine where and when the subject AV encountered a remote vehicle. By filtering and selecting these pairs of subject-vehicle/remote-vehicle instances, kinematic estimates based on sensor data of the subject vehicle can be validated using ground-truth kinematic characteristics that are recoverable from data generated by the remote vehicle localization and control systems. By utilizing the ground-truth data associated with remote vehicle bag data, kinematics models used to estimate/predict kinematic characteristics of moving objects can be improved through training. As discussed in further detail below, the kinematics models can include various machine-learning models, for example, that are deployed as part of an AV perception stack.

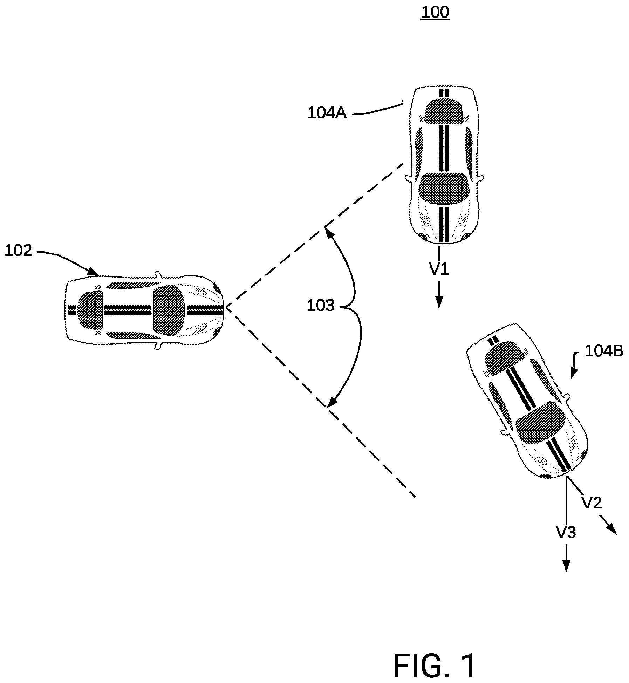

FIG. 1 conceptually illustrates an example environment 100 in which a kinematic prediction model of the disclosed technology can be implemented. In the example scenario of environment 100, subject vehicle 102 encounters two remote vehicles 104A and 104B. Sensor data collected by subject vehicle 102 can indicate the encounter with remote vehicles, 104A, 104B (collectively remote vehicles 104), when the remote vehicles 104 pass through a field-of-view (FOV) 103 of one or more sensors of subject vehicle 102.

In practice, a perception system of subject vehicle 102 can estimate (or predict) kinematic characteristics of various objects in the surrounding environment, including remote vehicles 104. For example, based on the sensor data collected by subject vehicle 102, the perception system of subject vehicle 102 can estimate or predict kinematic characteristics about remote vehicles 104, including but not limited to: speed, velocity, acceleration, pose, and/or momentum, etc. By way of example, subject vehicle 102 may estimate a velocity of remote vehicle 104A (e.g., vector V1), and a velocity for remote vehicle 104B (e.g., vectors V2, V3). The sensor data collected by subject vehicle 102, as well as the estimates of remote vehicle kinematic characteristics, can be stored as recorded bag data associated with subject vehicle 102. In turn, actual or ground-truth kinematic characteristics can be stored to bag data by each of remote vehicles 104A and 104B. For example, remote vehicles 104A and 104B can be AVs that utilize high-accuracy localization and control systems, and therefore, that have accurate measures of their respective kinematic characteristics.

In some aspects, sensor data (or bag data) for each subject vehicle and each remote vehicle 104 can be stored to a database. By leveraging the (high-accuracy) ground-truth kinematic data measured and collected by remote vehicles 104, kinematic estimates made by a perception system of subject vehicle 102, or by other perception systems, can be validated and improved, for example, using machine-learning training techniques.

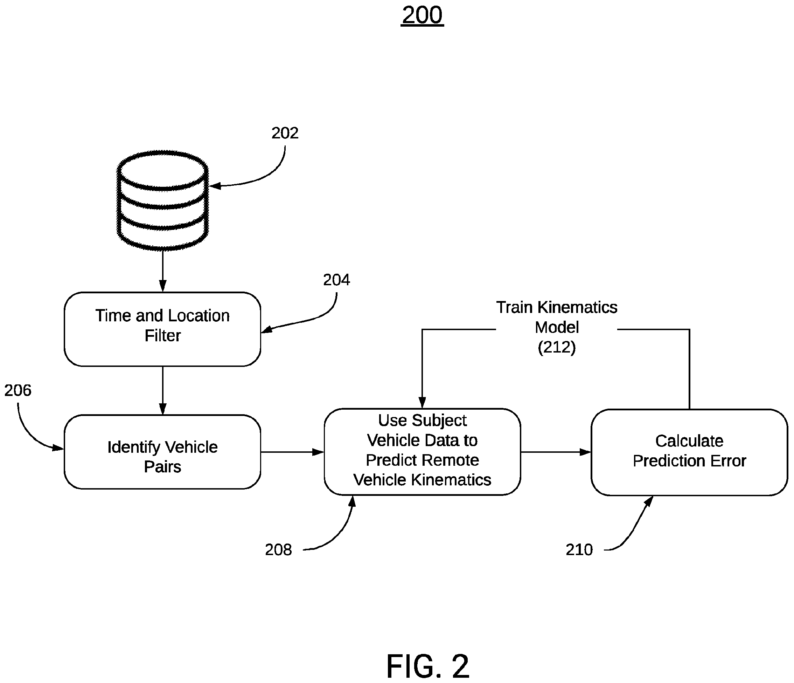

In some approaches, stores of legacy (bag) data can be filtered to identify spatio-temporally related data pairs, such as, to compare sensor (or bag) data of different AV's during encounters. As discussed in further detail with respect to FIG. 2, legacy data stores can be filtered based on localization information (e.g., geolocation information), and timestamps to identify instances of AV encounters. Such instances can yield data sets that include kinematic predictions (e.g., as made by a subject AV), and ground-truth kinematic characteristics (e.g., as recorded by one or more remote AVs).

FIG. 2 illustrates an example system 200 for training a kinematics model, according to some aspects of the disclosed technology. In the example of FIG. 2, database 202 represents a repository of legacy sensor data, for example, that has been collected by multiple AVs during the course of driving operations. As discussed above, database 202 can include AV bag data, for example, that includes data or metadata about various aspects of driving operation. By way of example, data stores in database 202 can include raw sensor data that is collected from different perspectives of various AVs, including but not limited to sensor data from one or more LiDAR, radar, or camera sensors. Bag data can also include data or metadata that is generated from various vehicle systems, such as AV perception, localization and/or control systems. By way of example, bag data may include kinematic predictions (or estimates) that were made by an AV perception system, and bag data can also include localization information, such as information indicating a position/location, baring, and/or pose of a corresponding AV. As discussed above, the bag data can also include ground-truth measurements of AV kinematics, for example, that are generated from the perspective of an associated (subject AV) control and/or localization system.

The AV data stored in database 202 can be filtered/sorted based on time and location parameters (block 204). For example, location information for a subject AV may be used to determine if and/or when the subject AV may have encountered other AVs (e.g., one or more other remote AVs), as discussed above with respect to FIG. 1. In some instances, two or more AVs may be proximately located, but may not have sensor data indicating perception of the other. As such, vehicle pose and/or bearing information can also be used to identify potential remote vehicles that may have been encountered by a subject AV, and for which data (or metadata) corresponding with the remote vehicle has been recorded by the subject AV. For example, time, location, and bearing/pose information can be used to identify instances where the collected sensor data of a subject AV reflects an encounter with a remote vehicle (block 206), i.e., where the remote vehicle passed through a field-of-view of one or more sensors of the subject AV.

Once these vehicle pairs have been identified, then sensor data collected by subject vehicle can be used to make predictions about kinematic characteristics of the remote vehicle, e.g., predicted kinematic characteristics (block 208). Predictions about the kinematics of an object, such as a remote vehicle, can be made using one or more machine-learning models, for example, that are configured to ingest sensor data and estimate (or predict) kinematic properties of the associated object. In some aspects, predicted kinematic characteristics of the remote vehicle may be stored in existing bag data, for example, indicating predictions made at a time the subject AV encountered the remote AV/s.

Irrespective of whether sensor data of the subject AV is used to predict new kinematic characteristics for the remote AV, or whether legacy kinematic predictions are used, the predicted kinematic characteristics can be verified/validated by comparison with ground-truth kinematic characteristics determined based on sensor data associated with the one or more remote vehicles. That is, the predicted kinematic characteristics can be compared with ground-truth kinematic characteristics indicated by the remote vehicle sensor data, for example, that indicate, speed, velocity, and/or acceleration characteristics of the remote vehicle. In some aspects, differences in the predicted kinematic characteristics and the ground-truth kinematic characteristics can be used to determine/calculate a prediction error, for example, that indicates an amount by which the predicted kinematic characteristics deviate from actual (ground-truth) kinematics (block 210). Prediction errors can be back-propagated, for example, to train or update one or more layers of the kinematics model used to perform the prediction (block 212).

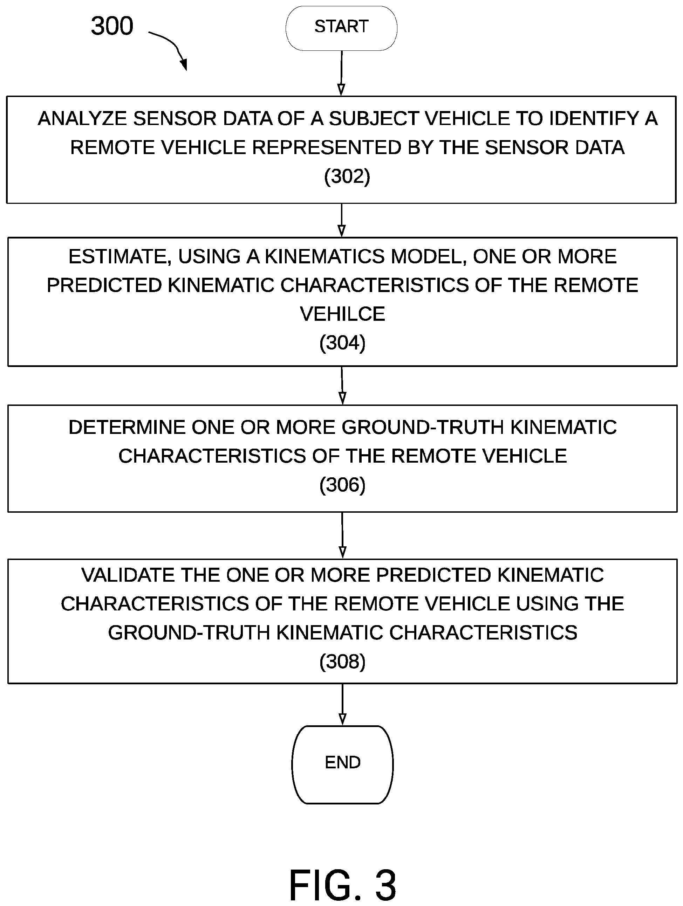

FIG. 3 illustrates a flow diagram of an example process 300 for training a kinematics model. At step 302, the process 300 includes analyzing sensor data of a subject vehicle to identify a remote vehicle represented by the sensor data. As discussed above, the identification of vehicle pairs can be based on spatio-temporal information for the subject vehicle and one or more remote vehicles. Further to the example discussed above with respect to FIG. 1, geolocation and timestamp information can be used to identify instances where a subject vehicle (or subject AV), has encountered one or more remote vehicles (or remote AVs). In such instances, the remote vehicle can be represented in sensor data collected by the subject AV. In the example environment 100 of FIG. 1, a subject AV (e.g., AV 102) can collect information about AV 104, as AV 104 passes through a field of view 103 of one or more sensors associated with subject AV 102.

Sensor data corresponding with the subject AV and/or the remote AV/s can be stored in bag data for the associated vehicle. As such, time and location information can be used to filter/search stores of legacy AV data (e.g., database 202), to identify AV encounters.

At step 304, the process 300 includes estimating, using the kinematics model, one or more predicted kinematic characteristics of the remote vehicle, wherein the one or more predicted kinematic characteristics are based on the sensor data of the subject vehicle.

At step 306, the process 300 includes determining, based on bag data associated with the remote vehicle, one or more ground-truth kinematic characteristics of the remote vehicle. As discussed above, the ground-truth kinematic characteristics can be recovered from bag data (or sensor data) that was recorded or generated by the subject vehicle. For example, ground-truth kinematic characteristics reflecting speed, velocity, pose and/or acceleration information of the remote AV can be stored to bag data for the remote vehicle. In some aspects, the ground-truth kinematic characteristics can be based on estimates or measurements made by local systems of the remote vehicle, such as a localization or control system of the remote AV. Because localization and control system measurements are typically more accurate than kinematic predictions, the predicted kinematics of the remote vehicle can be validated using the one or more ground-truth kinematic characteristics of the remote vehicle (step 308). In some implementations, validating the predicted kinematic characteristics can include comparing the predicted kinematic characteristics to the ground-truth kinematic characteristics, e.g., to calculate an error associated with the one or more predicted kinematic characteristics of the remote vehicle, and updating the kinematics model based on the error associated with the one or more predicted kinematic characteristics. By way of example, the error (e.g., the difference between the predicted and ground-truth kinematic characteristics) may be back propagated to one or more layers and/or weights of a machine-learning model. In this manner, the kinematics model can be updated to continually learn and thereby improve kinematic estimation accuracy.

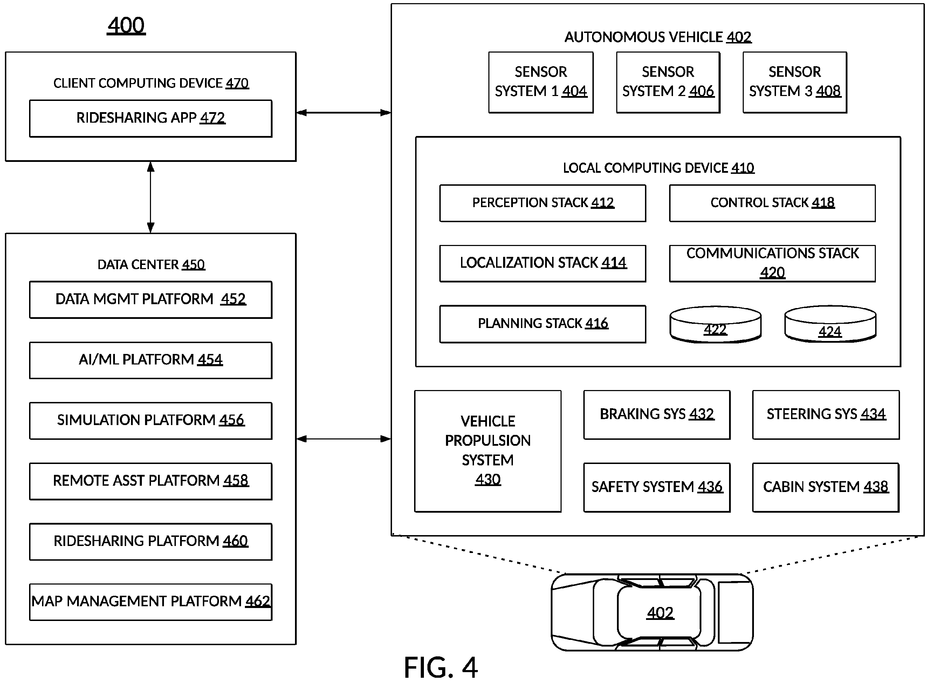

Turning now to FIG. 4 illustrates an example of an AV management system 400. One of ordinary skill in the art will understand that, for the AV management system 400 and any system discussed in the present disclosure, there can be additional or fewer components in similar or alternative configurations. The illustrations and examples provided in the present disclosure are for conciseness and clarity. Other embodiments may include different numbers and/or types of elements, but one of ordinary skill the art will appreciate that such variations do not depart from the scope of the present disclosure.

AV management system 400 includes an AV 402, a data center 450, and a client computing device 470. The AV 402, the data center 450, and the client computing device 470 can communicate with one another over one or more networks (not shown), such as a public network (e.g., the Internet, an Infrastructure as a Service (IaaS) network, a Platform as a Service (PaaS) network, a Software as a Service (SaaS) network, other Cloud Service Provider (CSP) network, etc.), a private network (e.g., a Local Area Network (LAN), a private cloud, a Virtual Private Network (VPN), etc.), and/or a hybrid network (e.g., a multi-cloud or hybrid cloud network, etc.).

AV 402 can navigate about roadways without a human driver based on sensor signals generated by multiple sensor systems 404, 406, and 408. The sensor systems 404-408 can include different types of sensors and can be arranged about the AV 402. For instance, the sensor systems 404-408 can comprise Inertial Measurement Units (IMUs), cameras (e.g., still image cameras, video cameras, etc.), light sensors (e.g., LIDAR systems, ambient light sensors, infrared sensors, etc.), RADAR systems, GPS receivers, audio sensors (e.g., microphones, Sound Navigation and Ranging (SONAR) systems, ultrasonic sensors, etc.), engine sensors, speedometers, tachometers, odometers, altimeters, tilt sensors, impact sensors, airbag sensors, seat occupancy sensors, open/closed door sensors, tire pressure sensors, rain sensors, and so forth. For example, the sensor system 404 can be a camera system, the sensor system 406 can be a LIDAR system, and the sensor system 408 can be a RADAR system. Other embodiments may include any other number and type of sensors.

AV 402 can also include several mechanical systems that can be used to maneuver or operate AV 402. For instance, the mechanical systems can include vehicle propulsion system 430, braking system 432, steering system 434, safety system 436, and cabin system 438, among other systems. Vehicle propulsion system 430 can include an electric motor, an internal combustion engine, or both. The braking system 432 can include an engine brake, brake pads, actuators, and/or any other suitable componentry configured to assist in decelerating AV 402. The steering system 434 can include suitable componentry configured to control the direction of movement of the AV 402 during navigation. Safety system 436 can include lights and signal indicators, a parking brake, airbags, and so forth. The cabin system 438 can include cabin temperature control systems, in-cabin entertainment systems, and so forth. In some embodiments, the AV 402 may not include human driver actuators (e.g., steering wheel, handbrake, foot brake pedal, foot accelerator pedal, turn signal lever, window wipers, etc.) for controlling the AV 402. Instead, the cabin system 438 can include one or more client interfaces, e.g., Graphical User Interfaces (GUIs), Voice User Interfaces (VUIs), etc., for controlling certain aspects of the mechanical systems 430-438.

AV 402 can additionally include a local computing device 410 that is in communication with the sensor systems 404-408, the mechanical systems 430-438, the data center 450, and the client computing device 470, among other systems. The local computing device 410 can include one or more processors and memory, including instructions that can be executed by the one or more processors. The instructions can make up one or more software stacks or components responsible for controlling the AV 402; communicating with the data center 450, the client computing device 470, and other systems; receiving inputs from riders, passengers, and other entities within the AV's environment; logging metrics collected by the sensor systems 404-408; and so forth. In this example, the local computing device 410 includes a perception stack 412, a mapping and localization stack 414, a planning stack 416, a control stack 418, a communications stack 420, an HD geospatial database 422, and an AV operational database 424, among other stacks and systems.

Perception stack 412 can enable the AV 402 to "see" (e.g., via cameras, LIDAR sensors, infrared sensors, etc.), "hear" (e.g., via microphones, ultrasonic sensors, RADAR, etc.), and "feel" (e.g., pressure sensors, force sensors, impact sensors, etc.) its environment using information from the sensor systems 404-408, the mapping and localization stack 414, the HD geospatial database 422, other components of the AV, and other data sources (e.g., the data center 450, the client computing device 470, third-party data sources, etc.). Perception stack 412 can detect and classify objects and determine their current and predicted locations, speeds, directions, and the like. In addition, the perception stack 412 can determine the free space around the AV 402 (e.g., to maintain a safe distance from other objects, change lanes, park the AV, etc.). The perception stack 412 can also identify environmental uncertainties, such as where to look for moving objects, flag areas that may be obscured or blocked from view, and so forth.

Mapping and localization stack 414 can determine the AV's position and orientation (pose) using different methods from multiple systems (e.g., GPS, IMUs, cameras, LIDAR, RADAR, ultrasonic sensors, the HD geospatial database 422, etc.). For example, in some embodiments, the AV 402 can compare sensor data captured in real-time by the sensor systems 404-408 to data in the HD geospatial database 422 to determine its precise (e.g., accurate to the order of a few centimeters or less) position and orientation. The AV 402 can focus its search based on sensor data from one or more first sensor systems (e.g., GPS) by matching sensor data from one or more second sensor systems (e.g., LIDAR). If the mapping and localization information from one system is unavailable, the AV 402 can use mapping and localization information from a redundant system and/or from remote data sources.

The planning stack 416 can determine how to maneuver or operate the AV 402 safely and efficiently in its environment. For example, the planning stack 416 can receive the location, speed, and direction of the AV 402, geospatial data, data regarding objects sharing the road with the AV 402 (e.g., pedestrians, bicycles, vehicles, ambulances, buses, cable cars, trains, traffic lights, lanes, road markings, etc.) or certain events occurring during a trip (e.g., emergency vehicle blaring a siren, intersections, occluded areas, street closures for construction or street repairs, double-parked cars, etc.), traffic rules and other safety standards or practices for the road, user input, and other relevant data for directing the AV 402 from one point to another. The planning stack 416 can determine multiple sets of one or more mechanical operations that the AV 402 can perform (e.g., go straight at a specified rate of acceleration, including maintaining the same speed or decelerating; turn on the left blinker, decelerate if the AV is above a threshold range for turning, and turn left; turn on the right blinker, accelerate if the AV is stopped or below the threshold range for turning, and turn right; decelerate until completely stopped and reverse; etc.), and select the best one to meet changing road conditions and events. If something unexpected happens, the planning stack 416 can select from multiple backup plans to carry out. For example, while preparing to change lanes to turn right at an intersection, another vehicle may aggressively cut into the destination lane, making the lane change unsafe. The planning stack 416 could have already determined an alternative plan for such an event, and upon its occurrence, help to direct the AV 402 to go around the block instead of blocking a current lane while waiting for an opening to change lanes.

The control stack 418 can manage the operation of the vehicle propulsion system 430, the braking system 432, the steering system 434, the safety system 436, and the cabin system 438. The control stack 418 can receive sensor signals from the sensor systems 404-408 as well as communicate with other stacks or components of the local computing device 410 or a remote system (e.g., the data center 450) to effectuate operation of the AV 402. For example, the control stack 418 can implement the final path or actions from the multiple paths or actions provided by the planning stack 416. This can involve turning the routes and decisions from the planning stack 416 into commands for the actuators that control the AV's steering, throttle, brake, and drive unit.

The communication stack 420 can transmit and receive signals between the various stacks and other components of the AV 402 and between the AV 402, the data center 450, the client computing device 470, and other remote systems. The communication stack 420 can enable the local computing device 410 to exchange information remotely over a network, such as through an antenna array or interface that can provide a metropolitan WIFI network connection, a mobile or cellular network connection (e.g., Third Generation (3G), Fourth Generation (4G), Long-Term Evolution (LTE), 5th Generation (5G), etc.), and/or other wireless network connection (e.g., License Assisted Access (LAA), Citizens Broadband Radio Service (CBRS), MULTEFIRE, etc.). The communication stack 420 can also facilitate local exchange of information, such as through a wired connection (e.g., a user's mobile computing device docked in an in-car docking station or connected via Universal Serial Bus (USB), etc.) or a local wireless connection (e.g., Wireless Local Area Network (WLAN), Bluetooth^{®}, infrared, etc.).

The HD geospatial database 422 can store HD maps and related data of the streets upon which the AV 402 travels. In some embodiments, the HD maps and related data can comprise multiple layers, such as an areas layer, a lanes and boundaries layer, an intersections layer, a traffic controls layer, and so forth. The areas layer can include geospatial information indicating geographic areas that are drivable (e.g., roads, parking areas, shoulders, etc.) or not drivable (e.g., medians, sidewalks, buildings, etc.), drivable areas that constitute links or connections (e.g., drivable areas that form the same road) versus intersections (e.g., drivable areas where two or more roads intersect), and so on. The lanes and boundaries layer can include geospatial information of road lanes (e.g., lane centerline, lane boundaries, type of lane boundaries, etc.) and related attributes (e.g., direction of travel, speed limit, lane type, etc.). The lanes and boundaries layer can also include 3D attributes related to lanes (e.g., slope, elevation, curvature, etc.). The intersections layer can include geospatial information of intersections (e.g., crosswalks, stop lines, turning lane centerlines and/or boundaries, etc.) and related attributes (e.g., permissive, protected/permissive, or protected only left turn lanes; legal or illegal U-turn lanes; permissive or protected only right turn lanes; etc.). The traffic controls lane can include geospatial information of traffic signal lights, traffic signs, and other road objects and related attributes.

The AV operational database 424 can store raw AV data generated by the sensor systems 404-408 and other components of the AV 402 and/or data received by the AV 402 from remote systems (e.g., the data center 450, the client computing device 470, etc.). In some embodiments, the raw AV data can include HD LIDAR point cloud data, image data, RADAR data, GPS data, and other sensor data that the data center 450 can use for creating or updating AV geospatial data as discussed further below with respect to FIG. 2 and elsewhere in the present disclosure.

The data center 450 can be a private cloud (e.g., an enterprise network, a co-location provider network, etc.), a public cloud (e.g., an Infrastructure as a Service (IaaS) network, a Platform as a Service (PaaS) network, a Software as a Service (SaaS) network, or other Cloud Service Provider (CSP) network), a hybrid cloud, a multi-cloud, and so forth. The data center 450 can include one or more computing devices remote to the local computing device 410 for managing a fleet of AVs and AV-related services. For example, in addition to managing the AV 402, the data center 450 may also support a ridesharing service, a delivery service, a remote/roadside assistance service, street services (e.g., street mapping, street patrol, street cleaning, street metering, parking reservation, etc.), and the like.

The data center 450 can send and receive various signals to and from the AV 402 and client computing device 470. These signals can include sensor data captured by the sensor systems 404-408, roadside assistance requests, software updates, ridesharing pick-up and drop-off instructions, and so forth. In this example, the data center 450 includes a data management platform 452, an Artificial Intelligence/Machine Learning (AI/ML) platform 454, a simulation platform 456, a remote assistance platform 458, a ridesharing platform 460, and map management system platform 462, among other systems.

Data management platform 452 can be a "big data" system capable of receiving and transmitting data at high velocities (e.g., near real-time or real-time), processing a large variety of data, and storing large volumes of data (e.g., terabytes, petabytes, or more of data). The varieties of data can include data having different structure (e.g., structured, semi-structured, unstructured, etc.), data of different types (e.g., sensor data, mechanical system data, ridesharing service, map data, audio, video, etc.), data associated with different types of data stores (e.g., relational databases, key-value stores, document databases, graph databases, column-family databases, data analytic stores, search engine databases, time series databases, object stores, file systems, etc.), data originating from different sources (e.g., AVs, enterprise systems, social networks, etc.), data having different rates of change (e.g., batch, streaming, etc.), or data having other heterogeneous characteristics. The various platforms and systems of the data center 450 can access data stored by the data management platform 452 to provide their respective services.

The AI/ML platform 454 can provide the infrastructure for training and evaluating machine learning algorithms for operating the AV 402, the simulation platform 456, the remote assistance platform 458, the ridesharing platform 460, the map management system platform 462, and other platforms and systems. Using the AI/ML platform 454, data scientists can prepare data sets from the data management platform 452; select, design, and train machine learning models; evaluate, refine, and deploy the models; maintain, monitor, and retrain the models; and so on.

The simulation platform 456 can enable testing and validation of the algorithms, machine learning models, neural networks, and other development efforts for the AV 402, the remote assistance platform 458, the ridesharing platform 460, the map management system platform 462, and other platforms and systems. The simulation platform 456 can replicate a variety of driving environments and/or reproduce real-world scenarios from data captured by the AV 402, including rendering geospatial information and road infrastructure (e.g., streets, lanes, crosswalks, traffic lights, stop signs, etc.) obtained from the map management system platform 462; modeling the behavior of other vehicles, bicycles, pedestrians, and other dynamic elements; simulating inclement weather conditions, different traffic scenarios; and so on.

The remote assistance platform 458 can generate and transmit instructions regarding the operation of the AV 402. For example, in response to an output of the AI/ML platform 454 or other system of the data center 450, the remote assistance platform 458 can prepare instructions for one or more stacks or other components of the AV 402.

The ridesharing platform 460 can interact with a customer of a ridesharing service via a ridesharing application 472 executing on the client computing device 470. The client computing device 470 can be any type of computing system, including a server, desktop computer, laptop, tablet, smartphone, smart wearable device (e.g., smart watch, smart eyeglasses or other Head-Mounted Display (HMD), smart ear pods or other smart in-ear, on-ear, or over-ear device, etc.), gaming system, or other general purpose computing device for accessing the ridesharing application 472. The client computing device 470 can be a customer's mobile computing device or a computing device integrated with the AV 402 (e.g., the local computing device 410). The ridesharing platform 460 can receive requests to be picked up or dropped off from the ridesharing application 472 and dispatch the AV 402 for the trip.

Map management system platform 462 can provide a set of tools for the manipulation and management of geographic and spatial (geospatial) and related attribute data. The data management platform 452 can receive LIDAR point cloud data, image data (e.g., still image, video, etc.), RADAR data, GPS data, and other sensor data (e.g., raw data) from one or more AVs 402, UAVs, satellites, third-party mapping services, and other sources of geospatially referenced data. The raw data can be processed, and map management system platform 462 can render base representations (e.g., tiles (2D), bounding volumes (3D), etc.) of the AV geospatial data to enable users to view, query, label, edit, and otherwise interact with the data. Map management system platform 462 can manage workflows and tasks for operating on the AV geospatial data. Map management system platform 462 can control access to the AV geospatial data, including granting or limiting access to the AV geospatial data based on user-based, role-based, group-based, task-based, and other attribute-based access control mechanisms. Map management system platform 462 can provide version control for the AV geospatial data, such as to track specific changes that (human or machine) map editors have made to the data and to revert changes when necessary. Map management system platform 462 can administer release management of the AV geospatial data, including distributing suitable iterations of the data to different users, computing devices, AVs, and other consumers of HD maps. Map management system platform 462 can provide analytics regarding the AV geospatial data and related data, such as to generate insights relating to the throughput and quality of mapping tasks.

In some embodiments, the map viewing services of map management system platform 462 can be modularized and deployed as part of one or more of the platforms and systems of the data center 450. For example, the AI/ML platform 454 may incorporate the map viewing services for visualizing the effectiveness of various object detection or object classification models, the simulation platform 456 may incorporate the map viewing services for recreating and visualizing certain driving scenarios, the remote assistance platform 458 may incorporate the map viewing services for replaying traffic incidents to facilitate and coordinate aid, the ridesharing platform 460 may incorporate the map viewing services into the client application 472 to enable passengers to view the AV 402 in transit en route to a pick-up or drop-off location, and so on.

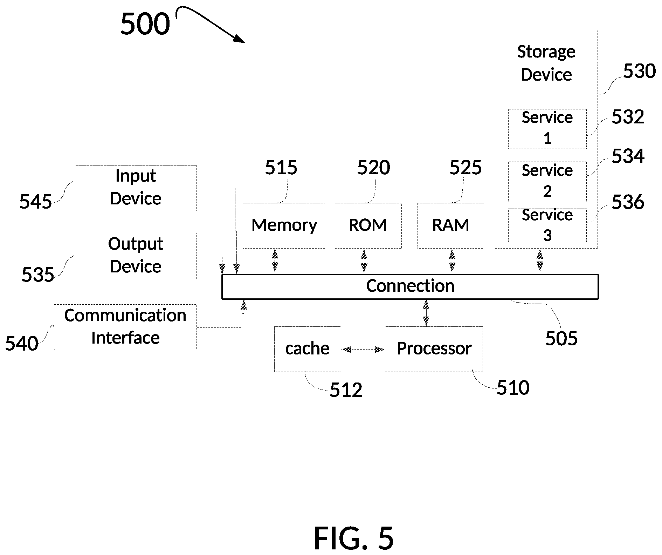

FIG. 5 illustrates an example apparatus (e.g., a processor-based system) with which some aspects of the subject technology can be implemented. For example, processor-based system 500 can be any computing device making up internal computing system 510, remote computing system 550, a passenger device executing the rideshare app 570, internal computing device 530, or any component thereof in which the components of the system are in communication with each other using connection 505. Connection 505 can be a physical connection via a bus, or a direct connection into processor 510, such as in a chipset architecture. Connection 505 can also be a virtual connection, networked connection, or logical connection.

In some embodiments, computing system 500 is a distributed system in which the functions described in this disclosure can be distributed within a datacenter, multiple data centers, a peer network, etc. In some embodiments, one or more of the described system components represents many such components each performing some or all of the function for which the component is described. In some embodiments, the components can be physical or virtual devices.

Example system 500 includes at least one processing unit (CPU or processor) 510 and connection 505 that couples various system components including system memory 515, such as read-only memory (ROM) 520 and random-access memory (RAM) 525 to processor 510. Computing system 500 can include a cache of high-speed memory 512 connected directly with, in close proximity to, or integrated as part of processor 510.

Processor 510 can include any general-purpose processor and a hardware service or software service, such as services 532, 534, and 536 stored in storage device 530, configured to control processor 510 as well as a special-purpose processor where software instructions are incorporated into the actual processor design. Processor 510 may essentially be a completely self-contained computing system, containing multiple cores or processors, a bus, memory controller, cache, etc. A multi-core processor may be symmetric or asymmetric.

To enable user interaction, computing system 500 includes an input device 545, which can represent any number of input mechanisms, such as a microphone for speech, a touch-sensitive screen for gesture or graphical input, keyboard, mouse, motion input, speech, etc. Computing system 500 can also include output device 535, which can be one or more of a number of output mechanisms known to those of skill in the art. In some instances, multimodal systems can enable a user to provide multiple types of input/output to communicate with computing system 500. Computing system 500 can include communications interface 540, which can generally govern and manage the user input and system output. The communication interface may perform or facilitate receipt and/or transmission wired or wireless communications via wired and/or wireless transceivers, including those making use of an audio jack/plug, a microphone jack/plug, a universal serial bus (USB) port/plug, an Apple^{®} Lightning^{®} port/plug, an Ethernet port/plug, a fiber optic port/plug, a proprietary wired port/plug, a BLUETOOTH^{®} wireless signal transfer, a BLUETOOTH^{®} low energy (BLE) wireless signal transfer, an IBEACON^{®} wireless signal transfer, a radio-frequency identification (RFID) wireless signal transfer, near-field communications (NFC) wireless signal transfer, dedicated short range communication (DSRC) wireless signal transfer, 802.11 Wi-Fi wireless signal transfer, wireless local area network (WLAN) signal transfer, Visible Light Communication (VLC), Worldwide Interoperability for Microwave Access (WiMAX), Infrared (IR) communication wireless signal transfer, Public Switched Telephone Network (PSTN) signal transfer, Integrated Services Digital Network (ISDN) signal transfer, 3G/4G/5G/LTE cellular data network wireless signal transfer, ad-hoc network signal transfer, radio wave signal transfer, microwave signal transfer, infrared signal transfer, visible light signal transfer, ultraviolet light signal transfer, wireless signal transfer along the electromagnetic spectrum, or some combination thereof.

Communication interface 540 may also include one or more Global Navigation Satellite System (GNSS) receivers or transceivers that are used to determine a location of the computing system 500 based on receipt of one or more signals from one or more satellites associated with one or more GNSS systems. GNSS systems include, but are not limited to, the US-based Global Positioning System (GPS), the Russia-based Global Navigation Satellite System (GLONASS), the China-based BeiDou Navigation Satellite System (BDS), and the Europe-based Galileo GNSS. There is no restriction on operating on any particular hardware arrangement, and therefore the basic features here may easily be substituted for improved hardware or firmware arrangements as they are developed.

Storage device 530 can be a non-volatile and/or non-transitory and/or computer-readable memory device and can be a hard disk or other types of computer readable media which can store data that are accessible by a computer, such as magnetic cassettes, flash memory cards, solid state memory devices, digital versatile disks, cartridges, a floppy disk, a flexible disk, a hard disk, magnetic tape, a magnetic strip/stripe, any other magnetic storage medium, flash memory, memristor memory, any other solid-state memory, a compact disc read only memory (CD-ROM) optical disc, a rewritable compact disc (CD) optical disc, digital video disk (DVD) optical disc, a blu-ray disc (BDD) optical disc, a holographic optical disk, another optical medium, a secure digital (SD) card, a micro secure digital (microSD) card, a Memory Stick^{®} card, a smartcard chip, a EMV chip, a subscriber identity module (SIM) card, a mini/micro/nano/pico SIM card, another integrated circuit (IC) chip/card, random access memory (RAM), static RAM (SRAM), dynamic RAM (DRAM), read-only memory (ROM), programmable read-only memory (PROM), erasable programmable read-only memory (EPROM), electrically erasable programmable read-only memory (EEPROM), flash EPROM (FLASHEPROM), cache memory (L1/L2/L3/L4/L5/L#), resistive random-access memory (RRAM/ReRAM), phase change memory (PCM), spin transfer torque RAM (STT-RAM), another memory chip or cartridge, and/or a combination thereof.

Storage device 530 can include software services, servers, services, etc., that when the code that defines such software is executed by the processor 510, it causes the system to perform a function. In some embodiments, a hardware service that performs a particular function can include the software component stored in a computer-readable medium in connection with the necessary hardware components, such as processor 510, connection 505, output device 535, etc., to carry out the function.

As understood by those of skill in the art, machine-learning based classification techniques can vary depending on the desired implementation. For example, machine-learning classification schemes can utilize one or more of the following, alone or in combination: hidden Markov models; recurrent neural networks; convolutional neural networks (CNNs); deep learning; Bayesian symbolic methods; general adversarial networks (GANs); support vector machines; image registration methods; applicable rule-based system. Where regression algorithms are used, they may include including but are not limited to: a Stochastic Gradient Descent Regressor, and/or a Passive Aggressive Regressor, etc.

Machine learning classification models can also be based on clustering algorithms (e.g., a Mini-batch K-means clustering algorithm), a recommendation algorithm (e.g., a Miniwise Hashing algorithm, or Euclidean Locality-Sensitive Hashing (LSH) algorithm), and/or an anomaly detection algorithm, such as a Local outlier factor. Additionally, machine-learning models can employ a dimensionality reduction approach, such as, one or more of: a Mini-batch Dictionary Learning algorithm, an Incremental Principal Component Analysis (PCA) algorithm, a Latent Dirichlet Allocation algorithm, and/or a Mini-batch K-means algorithm, etc.

Embodiments within the scope of the present disclosure may also include tangible and/or non-transitory computer-readable storage media or devices for carrying or having computer-executable instructions or data structures stored thereon. Such tangible computer-readable storage devices can be any available device that can be accessed by a general purpose or special purpose computer, including the functional design of any special purpose processor as described above. By way of example, and not limitation, such tangible computer-readable devices can include RAM, ROM, EEPROM, CD-ROM or other optical disk storage, magnetic disk storage or other magnetic storage devices, or any other device which can be used to carry or store desired program code in the form of computer-executable instructions, data structures, or processor chip design. When information or instructions are provided via a network or another communications connection (either hardwired, wireless, or combination thereof) to a computer, the computer properly views the connection as a computer-readable medium. Thus, any such connection is properly termed a computer-readable medium. Combinations of the above should also be included within the scope of the computer-readable storage devices.

Computer-executable instructions include, for example, instructions and data which cause a general-purpose computer, special purpose computer, or special purpose processing device to perform a certain function or group of functions. Computer-executable instructions also include program modules that are executed by computers in stand-alone or network environments. Generally, program modules include routines, programs, components, data structures, objects, and the functions inherent in the design of special-purpose processors, etc. that perform tasks or implement abstract data types. Computer-executable instructions, associated data structures, and program modules represent examples of the program code means for executing steps of the methods disclosed herein. The particular sequence of such executable instructions or associated data structures represents examples of corresponding acts for implementing the functions described in such steps.

Other embodiments of the disclosure may be practiced in network computing environments with many types of computer system configurations, including personal computers, hand-held devices, multi-processor systems, microprocessor-based or programmable consumer electronics, network PCs, minicomputers, mainframe computers, and the like. Embodiments may also be practiced in distributed computing environments where tasks are performed by local and remote processing devices that are linked (either by hardwired links, wireless links, or by a combination thereof) through a communications network. In a distributed computing environment, program modules may be located in both local and remote memory storage devices.

The invention is not limited to the disclosed exemplary embodiments, but by the scope of the following claims.

## Claims

1. An apparatus for training a kinematics model, comprising:
at least one memory; and
at least one processor coupled to the at least one memory, the at least one processor configured to:
analyze sensor data of a subject vehicle to identify a remote vehicle represented by the sensor data, wherein in particular the remote vehicle is an autonomous vehicle (AV);
estimate, using the kinematics model, one or more predicted kinematic characteristics of the remote vehicle, wherein the one or more predicted kinematic characteristics are based on the sensor data of the subject vehicle, and wherein the sensor data of the subject vehicle is an input to the kinematics model for estimating and predicting the one or more predicted kinematic characteristics;
determine, based on bag data recorded from and associated with the remote vehicle, one or more ground-truth kinematic characteristics of the remote vehicle, wherein bag data contain localization information;
verify the one or more predicted kinematic characteristics of the remote vehicle using the one or more ground-truth kinematic characteristics of the remote vehicle;
calculate an error, based on a difference between the one or more predicted kinematic characteristics and the one or more ground-truth kinematic characteristics, associated with the one or more predicted kinematic characteristics of the remote vehicle; and
update the kinematics model based on the error associated with the one or more predicted kinematic characteristics.

2. The apparatus of claim 1, wherein the one or more ground-truth kinematic characteristics of the remote vehicle are recorded by a localization system of the remote vehicle and stored on a database to be accessible by the subject vehicle.

3. The apparatus of claim 1, wherein the kinematics model is a machine-learning model.

4. The apparatus of claim 1, wherein the sensor data of the subject vehicle includes Light Detection and Ranging (LiDAR) sensor data, camera data, radar data, or a combination thereof.

5. The apparatus of claim 1, wherein the one or more predicted kinematic characteristics of the remote vehicle comprises a velocity estimate, an acceleration estimate, or a combination thereof.

6. A computer-implemented method for training a kinematics model, comprising:
analyzing sensor data of a subject vehicle to identify a remote vehicle represented by the sensor data, wherein the remote vehicle is in particular an autonomous vehicle (AV);
estimating, using the kinematics model, one or more predicted kinematic characteristics of the remote vehicle, wherein the one or more predicted kinematic characteristics are based on the sensor data of the subject vehicle, and wherein the sensor data of the subject vehicle is an input to the kinematics model for estimating and predicting the one or more predicted kinematic characteristics;
determining, based on bag data recorded from and associated with the remote vehicle, one or more ground-truth kinematic characteristics of the remote vehicle, wherein bag data contain localization information;
verifying the one or more predicted kinematic characteristics of the remote vehicle using the one or more ground-truth kinematic characteristics of the remote vehicle;
calculating an error, based on a difference between the one or more predicted kinematic characteristics and the one or more ground-truth kinematic characteristics, associated with the one or more predicted kinematic characteristics of the remote vehicle; and
updating the kinematics model based on the error associated with the one or more predicted kinematic characteristics.

7. The computer-implemented method of claim 6, wherein the one or more ground-truth kinematic characteristics of the remote vehicle are recorded by a localization system of the remote vehicle and stored on a database to be accessible by the subject vehicle.

8. The computer-implemented method of claim 6, wherein the kinematics model is a machine-learning model.

9. The computer-implemented method of claim 6, wherein the sensor data of the subject vehicle includes Light Detection and Ranging (LiDAR) sensor data, camera data, radar data, or a combination thereof.

10. The computer-implemented method of claim 6, wherein the one or more predicted kinematic characteristics of the remote vehicle comprises a velocity estimate, an acceleration estimate, or a combination thereof.

11. Computer program, **characterized in that** it comprises code means configured to, when executed on a computer, carry out the steps of the method according to any one claim 6 to 10.

12. A non-transitory computer-readable storage medium, **characterized in that** the computer program of claim 11 is stored on it.

## Patentansprüche

1. Vorrichtung zum Trainieren eines Kinematikmodells, umfassend:
zumindest einen Speicher; und
zumindest einen Prozessor, der mit dem zumindest einen Speicher gekoppelt ist, wobei der zumindest eine Prozessor ausgestaltet ist, um:
Sensordaten eines betreffenden Fahrzeugs zu analysieren, um ein durch die Sensordaten dargestelltes entferntes Fahrzeug zu identifizieren, wobei insbesondere das entfernte Fahrzeug ein autonomes Fahrzeug (AV) ist;
unter Verwendung des Kinematikmodells eine oder mehrere vorhergesagte kinematische Eigenschaften des entfernten Fahrzeugs zu schätzen, wobei die eine oder die mehreren vorhergesagten kinematischen Eigenschaften auf den Sensordaten des betreffenden Fahrzeugs basieren, und wobei die Sensordaten des betreffenden Fahrzeugs eine Eingabe in das Kinematikmodell zum Schätzen und Vorhersagen der einen oder der mehreren vorhergesagten kinematischen Eigenschaften sind;
basierend auf Bag-Daten, die von dem entfernten Fahrzeug aufgezeichnet werden und diesem zugehörig sind, eine oder mehrere kinematische Ground-Truth-Eigenschaften des entfernten Fahrzeugs zu ermitteln, wobei Bag-Daten eine Ortsbestimmungsinformation enthalten;
die eine oder die mehreren vorhergesagten kinematischen Eigenschaften des entfernten Fahrzeugs unter Verwendung der einen oder der mehreren kinematischen Ground-Truth-Eigenschaften des entfernten Fahrzeugs zu verifizieren;
basierend auf einer Differenz zwischen der einen oder den mehreren vorhergesagten kinematischen Eigenschaften und der einen oder den mehreren kinematischen Ground-Truth-Eigenschaften, die der einen oder den mehreren vorhergesagten kinematischen Eigenschaften des entfernten Fahrzeugs zugehörig sind, einen Fehler zu berechnen; und
das Kinematikmodell basierend auf dem Fehler, der der einen oder den mehreren vorhergesagten kinematischen Eigenschaften zugehörig ist, zu aktualisieren.

2. Vorrichtung nach Anspruch 1, wobei die eine oder die mehreren kinematischen Ground-Truth-Eigenschaften des entfernten Fahrzeugs durch ein Ortsbestimmungssystem des entfernten Fahrzeugs aufgezeichnet und in einer Datenbank für einen Zugriff durch das betreffende Fahrzeug gespeichert werden.

3. Vorrichtung nach Anspruch 1, wobei das Kinematikmodell ein Maschinenlernmodell ist.

4. Vorrichtung nach Anspruch 1, wobei die Sensordaten des betreffenden Fahrzeugs Light Detection and Ranging-Sensordaten (LiDAR-Sensordaten), Kameradaten, Radardaten oder eine Kombination davon umfassen.

5. Vorrichtung nach Anspruch 1, wobei die eine oder die mehreren vorhergesagten kinematischen Eigenschaften des entfernten Fahrzeugs einen Geschwindigkeitsschätzwert, einen Beschleunigungsschätzwert oder eine Kombination davon umfassen.

6. Durch einen Computer realisiertes Verfahren zum Trainieren eines Kinematikmodells, umfassend, dass:
Sensordaten eines betreffenden Fahrzeugs analysiert werden, um ein durch die Sensordaten dargestelltes entferntes Fahrzeug zu identifizieren, wobei insbesondere das entfernte Fahrzeug ein autonomes Fahrzeug (AV) ist;
unter Verwendung des Kinematikmodells eine oder mehrere vorhergesagte kinematische Eigenschaften des entfernten Fahrzeugs geschätzt werden, wobei die eine oder die mehreren vorhergesagten kinematischen Eigenschaften auf den Sensordaten des betreffenden Fahrzeugs basieren, und wobei die Sensordaten des betreffenden Fahrzeugs eine Eingabe in das Kinematikmodell zum Schätzen und Vorhersagen der einen oder der mehreren vorhergesagten kinematischen Eigenschaften sind;
basierend auf Bag-Daten, die von dem entfernten Fahrzeug aufgezeichnet werden und diesem zugehörig sind, eine oder mehrere kinematische Ground-Truth-Eigenschaften des entfernten Fahrzeugs ermittelt werden, wobei Bag-Daten eine Ortsbestimmungsinformation enthalten;
die eine oder die mehreren vorhergesagten kinematischen Eigenschaften des entfernten Fahrzeugs unter Verwendung der einen oder der mehreren kinematischen Ground-Truth-Eigenschaften des entfernten Fahrzeugs verifiziert werden;
basierend auf einer Differenz zwischen der einen oder den mehreren vorhergesagten kinematischen Eigenschaften und der einen oder den mehreren kinematischen Ground-Truth-Eigenschaften, die der einen oder den mehreren vorhergesagten kinematischen Eigenschaften des entfernten Fahrzeugs zugehörig sind, ein Fehler berechnet wird; und
das Kinematikmodell basierend auf dem Fehler, der der einen oder den mehreren vorhergesagten kinematischen Eigenschaften zugehörig ist, aktualisiert wird.

7. Durch einen Computer realisiertes Verfahren nach Anspruch 6, wobei die eine oder die mehreren kinematischen Ground-Truth-Eigenschaften des entfernten Fahrzeugs durch ein Ortsbestimmungssystem des entfernten Fahrzeugs aufgezeichnet und in einer Datenbank für einen Zugriff durch das betreffende Fahrzeug gespeichert werden.

8. Durch einen Computer realisiertes Verfahren nach Anspruch 6, wobei das Kinematikmodell ein Maschinenlernmodell ist.

9. Durch einen Computer realisiertes Verfahren nach Anspruch 6, wobei die Sensordaten des betreffenden Fahrzeugs Light Detection and Ranging-Sensordaten (LiDAR-Sensordaten), Kameradaten, Radardaten oder eine Kombination davon umfassen.

10. Durch einen Computer realisiertes Verfahren nach Anspruch 6, wobei die eine oder die mehreren vorhergesagten kinematischen Eigenschaften des entfernten Fahrzeugs einen Geschwindigkeitsschätzwert, einen Beschleunigungsschätzwert oder eine Kombination davon umfassen.

11. Computerprogramm, **dadurch gekennzeichnet, dass** es ein Code-Mittel umfasst, das ausgestaltet ist, um bei einer Ausführung an einem Computer die Schritte des Verfahrens nach einem der Ansprüche 6 bis 10 auszuführen.

12. Nicht-transitorisches durch einen Computer lesbares Speichermedium, **dadurch gekennzeichnet, dass** das Computerprogramm nach Anspruch 11 darauf gespeichert ist.

## Revendications

1. Appareil pour entraîner un modèle cinématique, comprenant :
au moins une mémoire ; et
au moins un processeur couplé à ladite au moins une mémoire, ledit au moins un processeur étant configuré pour :
analyser les données de capteur d'un véhicule sujet pour identifier un véhicule distant représenté par les données de capteur, dans lequel, en particulier, le véhicule distant est un véhicule autonome (AV) ;
estimer, à l'aide du modèle cinématique, une ou plusieurs caractéristiques cinématiques prédites du véhicule distant, dans lequel lesdites une ou plusieurs caractéristiques cinématiques prédites sont basées sur les données de capteur du véhicule sujet, et dans lequel les données de capteur du véhicule sujet sont une entrée du modèle cinématique pour estimer et prédire lesdites une ou plusieurs caractéristiques cinématiques prédites ;
déterminer, sur la base de données de sac enregistrées à partir du véhicule distant et associées à celui-ci, une ou plusieurs caractéristiques cinématiques de vérité terrain du véhicule distant, dans lequel les données de sac contiennent des informations de localisation ;
vérifier lesdites une ou plusieurs caractéristiques cinématiques prédites du véhicule distant à l'aide desdites une ou plusieurs caractéristiques cinématiques de vérité terrain du véhicule distant ;
calculer, sur la base d'une différence entre lesdites une ou plusieurs caractéristiques cinématiques prédites et lesdites une ou plusieurs caractéristiques cinématiques de vérité terrain, une erreur associée auxdites une ou plusieurs caractéristiques cinématiques prédites du véhicule distant ; et
mettre à jour le modèle cinématique sur la base de l'erreur associée auxdites une ou plusieurs caractéristiques cinématiques prédites.

2. Appareil selon la revendication 1, dans lequel lesdites une ou plusieurs caractéristiques cinématiques de vérité terrain du véhicule distant sont enregistrées par un système de localisation du véhicule distant et stockées dans une base de données accessible par le véhicule sujet.

3. Appareil selon la revendication 1, dans lequel le modèle cinématique est un modèle d'apprentissage automatique.

4. Appareil selon la revendication 1, dans lequel les données de capteur du véhicule sujet comprennent des données de capteur de détection et de télémétrie par la lumière (LiDAR), des données de caméra, des données de radar ou une combinaison de celles-ci.

5. Appareil selon la revendication 1, dans lequel lesdites une ou plusieurs caractéristiques cinématiques prédites du véhicule distant comprennent une estimation de vitesse, une estimation d'accélération ou une combinaison de celles-ci.

6. Procédé mis en œuvre par ordinateur pour entraîner un modèle cinématique, consistant à :
analyser les données de capteur d'un véhicule sujet pour identifier un véhicule distant représenté par les données de capteur, dans lequel le véhicule distant est en particulier un véhicule autonome (AV) ;
estimer, à l'aide du modèle cinématique, une ou plusieurs caractéristiques cinématiques prédites du véhicule distant, dans lequel lesdites une ou plusieurs caractéristiques cinématiques prédites sont basées sur les données de capteur du véhicule sujet, et dans lequel les données de capteur du véhicule sujet sont une entrée du modèle cinématique pour estimer et prédire lesdites une ou plusieurs caractéristiques cinématiques prédites ;
déterminer, sur la base de données de sac enregistrées à partir du véhicule distant et associées à celui-ci, une ou plusieurs caractéristiques cinématiques de vérité terrain du véhicule distant, dans lequel les données de sac contiennent des informations de localisation ;
vérifier lesdites une ou plusieurs caractéristiques cinématiques prédites du véhicule distant à l'aide desdites une ou plusieurs caractéristiques cinématiques de vérité terrain du véhicule distant ;
calculer, sur la base d'une différence entre lesdites une ou plusieurs caractéristiques cinématiques prédites et lesdites une ou plusieurs caractéristiques cinématiques de vérité terrain, une erreur associée auxdites une ou plusieurs caractéristiques cinématiques prédites du véhicule distant ; et
mettre à jour le modèle cinématique sur la base de l'erreur associée auxdites une ou plusieurs caractéristiques cinématiques prédites.

7. Procédé mis en œuvre par ordinateur selon la revendication 6, dans lequel lesdites une ou plusieurs caractéristiques cinématiques de vérité terrain du véhicule distant sont enregistrées par un système de localisation du véhicule distant et stockées dans une base de données accessible par le véhicule sujet.

8. Procédé mis en œuvre par ordinateur selon la revendication 6, dans lequel le modèle cinématique est un modèle d'apprentissage automatique.

9. Procédé mis en œuvre par ordinateur selon la revendication 6, dans lequel les données de capteur du véhicule sujet comprennent des données de capteur de détection et de télémétrie par la lumière (LiDAR), des données de caméra, des données de radar ou une combinaison de celles-ci.

10. Procédé mis en œuvre par ordinateur selon la revendication 6, dans lequel lesdites une ou plusieurs caractéristiques cinématiques prédites du véhicule distant comprennent une estimation de vitesse, une estimation d'accélération ou une combinaison de celles-ci.

11. Programme informatique, **caractérisé en ce qu'**il comprend des moyens de code configurés pour, lorsqu'ils sont exécutés sur un ordinateur, mettre en œuvre les étapes du procédé selon l'une quelconque des revendications 6 à 10.

12. Support de stockage non transitoire lisible par ordinateur, **caractérisé en ce que** le programme informatique de la revendication 11 est stocké sur celui-ci.
